# EUROPEAN PATENT SPECIFICATION

(11) **EP 2 801 792 B1**
(45) Date of publication and mention of the grant of the patent: **02.01.2019**
(21) Application number: 14157355.0
(22) Date of filing: 28.02.2014
(51) Int. Cl.: G01D 4/00

(54) **Non-intrusive load monitoring apparatus and method**
Eingriffsfreie Lastüberwachungsvorrichtung und Verfahren
Appareil et procédé de surveillance de charge non intrusive (NILM)

(30) Priority: 08.05.2013 KR 20130051779
(43) Date of publication of application: 12.11.2014
(73) Proprietor: Samsung Electronics Co., Ltd., Gyeonggi-do 16677 (KR)
(72) Inventor: Seo, Sung Mok, Gyeonggi-do (KR); Ravi, Mohanlal, Gyeonggi-do (KR); Park, Young Jin, Gyeonggi-do (KR)
(74) Representative: Walaski, Jan Filip

(56) References cited:
- WO-A2-2011/128883
- GB-A- 2 488 164
- US-A1- 2011 098 867
- US-A1- 2011 251 807

## Description

The present invention relates to a non-intrusive load monitoring (NILM) technique which senses the operating state of an appliance and predicts power consumption of the appliance through a single point sensor.

In order to successfully introduce a smart grid employed to stably and effectively use electrical energy into homes, understanding and participation of power consumers as well as electricity producers and energy policy planners is important. From the power consumer's viewpoint, the benefit of the smart grid is reduction of energy costs and this may be easily acquired through energy consumption reduction.

Energy consumption reduction methods mainly referred to in smart grid-related researches may be divided into a method of feeding an existing energy consumption state back to a consumer and inducing the consumer to participate in energy consumption reduction activity therethrough, and a method of automatically reducing energy consumption without consumer's recognition. The effects of the former have been analyzed by the Electric Power Research Institute (EPRI) in the U.S. Based on research results, simple provision of a power consumption pattern to a consumer may induce energy consumption reduction effects, and it is reported that, particularly, if information segmented according to devices is provided in real time, energy consumption is reduced by an average of 12%.

The latter is implemented in a manner in which a home appliance corresponding to the smart grid is connected to a home area network (HAN), and the HAN is operated in connection with a demand control program of an electricity producer through a smart meter so that energy consumption is concentrated when a power rate is inexpensive.

From the power consumer's viewpoint, the automated method is attractive but for this purpose, execution of the demand control program and replacement of current power meters and home appliances with home appliances corresponding to the smart grid place too heavy a burden on the electricity producer.

The former is effective in reduction of energy consumption but entails high costs to construct such a system. As a general method of constructing an energy monitoring system, a power consumption sensing device called a smart plug or a smart socket is installed on each of home appliances and power rate information is collected and displayed by an in-home display (IHD) serving as a sink through a wireless communication unit. Considerable costs and effort are taken to install the smart plug in each home appliance and to maintain the smart plug. In order to reduce such costs, research into a non-intrusive load monitoring (NILM) technique, in which a composite power signal acquired by combining power consumption patterns of all appliances in a home is observed by monitoring one power line to which all the appliances are connected, and power consumption patterns of the respective appliances are separated from the observed composite power signal and provided to a consumer, has been carried out.

In general, the NILM technique includes a data acquisition module, an event detection module, a feature extraction module, an appliance identification module, and a power estimation module. The event detection module receives any feature which may sense change of power in an appliance, and senses change of a power pattern by applying an edge or event detection algorithm thereto. For this purpose, a first-difference algorithm or a generalized likelihood ratio (GLR) algorithm has conventionally been applied. As another method, a sensor is provided around a power supply line of each appliance and senses state change of each appliance through change of an electromagnetic field.

The document WO2011/128883 discloses a NILM apparatus according to the state of the art.

However, the above-described conventional methods have problems, as follows.

First, in the case of the GLR algorithm method, it may be difficult to set a window size and a critical value, probability calculation and repeated calculation in two windows are required and thus, calculation time is long and accuracy is low, as compared to the first-difference algorithm. Further, since most event detection modules detect an event using change of effective power as a feature, the GLR algorithm method is limited in identification of both an appliance having high power consumption and an appliance having low power consumption.

In the case of the EMF-based event detection method, each of respective appliances requires a sensor for EMF detection and thus, interference between the sensors needs to be solved, and a communication unit between the respective sensors and a processor to collect detected results of the respective sensors is required.

Therefore, it is an aspect of the present disclosure to provide a non-intrusive load monitoring (NILM) apparatus and method according to claims 1 and 6 respectively.

It is another aspect of the present disclosure to provide a non-intrusive load monitoring (NILM) apparatus and method which may identify a load using the superposition theory. Additional aspects of the disclosure will be set forth in part in the description which follows and, in part, will be apparent from the description, or may be learned by practice of the disclosure.

In accordance with one aspect of the present disclosure, a non-intrusive load monitoring (NILM) apparatus includes a sensor unit to collect information regarding power consumption of home appliances, and a controller detecting power consumption-related events occurring in the home appliances based on power factor and apparent power information among the power consumption information collected by the sensor unit.

The controller may include a data collection logic capturing raw data from the power consumption information collected by the sensor unit, a data processing logic acquiring apparent power and real power of the power consumption from the raw data and generating the power factor information from the apparent power and the real power.

The raw data may include steady-state signals and transient signals.

The controller further includes a feature extraction logic extracting features of power consumption patterns of the home appliances from an event detection result of the event detection logic, and an appliance identification logic identifies the home appliances through analysis of data regarding the features extracted by the feature extraction logic.

The data processing logic may acquire current harmonic power (CHP) coefficients of the power consumption from the raw data, and the appliance identification logic may identify the home appliances using the CHP coefficients.

The appliance identification logic may use the superposition theory when the appliance identification logic identifies the home appliances using the CHP coefficients.

In accordance with another aspect of the present disclosure, a non-intrusive load monitoring (NILM) apparatus includes a sensor unit to collect information regarding power consumption of home appliances, and a controller detecting power consumption-related events occurring in the home appliances based on power factor information and apparent power information among the power consumption information collected by the sensor unit.

The controller may include a data collection logic capturing raw data from the power consumption information collected by the sensor unit, a data processing logic acquiring apparent power and real power of the power consumption from the raw data and generating the power factor information from the apparent power and the real power, and an event detection logic detecting the power consumption-related events based on the power factor information.

The raw data may include steady-state signals and transient signals.

The event detection logic may detect the power consumption-related events using a window-based first difference event detection method.

The controller further includes a feature extraction logic extracting features of power consumption patterns of the home appliances from an event detection result of the event detection logic, and an appliance identification logic identifies the home appliances through analysis of data regarding the features extracted by the feature extraction logic.

The data processing logic may acquire current harmonic power (CHP) coefficients of the power consumption from the raw data, and the appliance identification logic may identify the home appliances using the CHP coefficients.

The appliance identification logic may use the superposition theory when the appliance identification logic identifies the home appliances using the CHP coefficients.

In accordance with another aspect of the present disclosure, a non-intrusive load monitoring (NILM) method includes collecting information regarding power consumption of home appliances and detecting power consumption-related events occurring in the home appliances based on power factor information among the collected power consumption information.

The detection of the power consumption-related events may include capturing raw data from the power consumption, acquiring apparent power and real power of the power consumption from the raw data and generating the power factor information from the apparent power and the real power, and detecting the power consumption-related events based on the power factor information.

The raw data may include steady-state signals and transient signals.

The NILM method may further include extracting features of power consumption patterns of the home appliances from a result of the event detection and identifying the home appliances through analysis of data regarding the extracted features.

Current harmonic power (CHP) coefficients of the power consumption may be acquired from the raw data, and the identification of the home appliances may be performed using the CHP coefficients.

The superposition theory may be used when the home appliances are identified using the CHP coefficients.

In accordance with a further aspect of the present disclosure, a non-intrusive load monitoring (NILM) method includes collecting information regarding power consumption of home appliances and detecting power consumption-related events occurring in the home appliances based on power factor information and apparent power information among the collected power consumption information.

The detection of the power consumption-related events may include capturing raw data from the power consumption, acquiring apparent power and real power of the power consumption from the raw data and generating the power factor information from the apparent power and the real power, and detecting the power consumption-related events based on the power factor information.

The raw data may include steady-state signals and transient signals.

The power consumption-related events may be detected using a window-based first difference event detection method.

The NILM method may further include extracting features of power consumption patterns of the home appliances from a result of the event detection and identifying the home appliances through analysis of data regarding the extracted features.

Current harmonic power (CHP) coefficients of the power consumption may be acquired from the raw data, and the identification of the home appliances may be performed using the CHP coefficients.

The superposition theory may be used when the home appliances are identified using the CHP coefficients.

These and/or other aspects of the disclosure will become apparent and more readily appreciated from the following description of the embodiments, taken in conjunction with the accompanying drawings of which:
FIG. 1 is a view illustrating a power supply system which supplies power to a home (or a workplace) through a distribution board in accordance with one embodiment of the present disclosure;
FIG. 2 is a view briefly illustrating the power supply system provided with a non-intrusive load monitoring (NILM) apparatus in accordance with the embodiment of the present disclosure;
FIG. 3 is a view illustrating configuration of the NILM apparatus in accordance with the embodiment of the present disclosure;
FIGS. 4(A) and 4(B) are views illustrating an event detection logic provided in a controller of an NILM apparatus in accordance with one embodiment of the present disclosure;
FIGS. 5(A) to 5(C) are views illustrating an event detection principle using a power factor in the event detection logic in accordance with the embodiment of the present disclosure;
FIG. 6 is a table comparatively illustrating test results of the NILM apparatus using a power factor in accordance with the embodiment of the present disclosure and a conventional NILM apparatus using real power;
FIGS. 7(A) to 7(D) are graphs comparatively illustrating event detection using real power and event detection using a power factor in accordance with the embodiment of the present disclosure;
FIGS. 8(A) and 8(B) are views illustrating an event detection logic provided on a controller of an NILM apparatus in accordance with another embodiment of the present disclosure;
FIG. 9 is a graph illustrating event detection of the event detection logic in accordance with the embodiment of the present disclosure;
FIGS. 10(A) and 10(B) are graphs illustrating a power factor information-based event detection example and an apparent power information-based event detection example; and
FIG. 11 is a graph illustrating the concept of appliance identification using a current harmonic power (CHP) coefficient.

Reference will now be made in detail to the embodiments of the present disclosure, examples of which are illustrated in the accompanying drawings, wherein like reference numerals refer to like elements throughout.

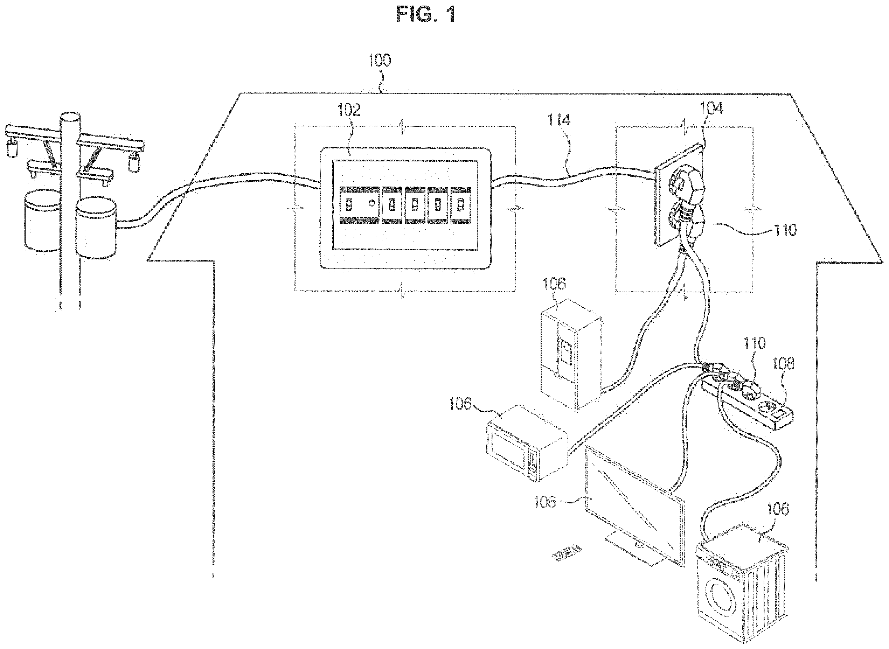

FIG. 1 is a view illustrating a power supply system which supplies power to a home (or a workplace) through a distribution board in accordance with one embodiment of the present disclosure. As exemplarily shown in FIG. 1, power supplied from an external power supply source to each home (or workplace) 100 is transmitted to a wall socket (or electric outlet) 104 provided in a bedroom, a living room, or a kitchen through a distribution board 102 provided in each home (or workplace) 100 via a power line 114.

Home appliances 106 using electricity as energy in the home (or workplace) 100 receive power directly through the wall socket 104, or receive power through a multi-tap 108 connected to the wall socket 104. The home appliances 106 correspond to loads consuming power.

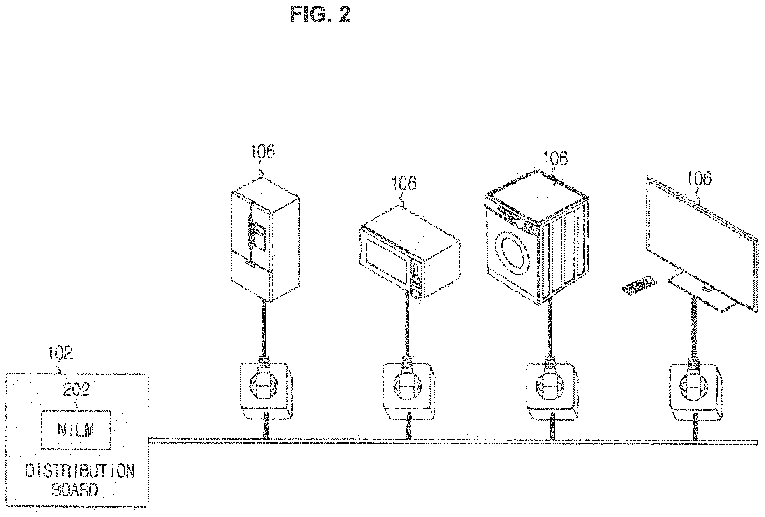

FIG. 2 is a view briefly illustrating the power supply system provided with a non-intrusive load monitoring (NILM) apparatus in accordance with the embodiment of the present disclosure. As exemplarily shown in FIG. 2, the home appliances 106 using power as energy receive power from the distribution board 102. An NILM apparatus 202 is provided on the distribution board 102. The NILM apparatus 102 analyzes changes of voltage and current in a power line supplying power to the home (or workplace) 100, and judges a power consumption pattern in the home (or workplace) 100, i.e., a level of power consumed by each home appliance 106, a time zone when each home appliance 106 consumes power, a power consumption type of each home appliance 106, etc., based on a result of analysis.

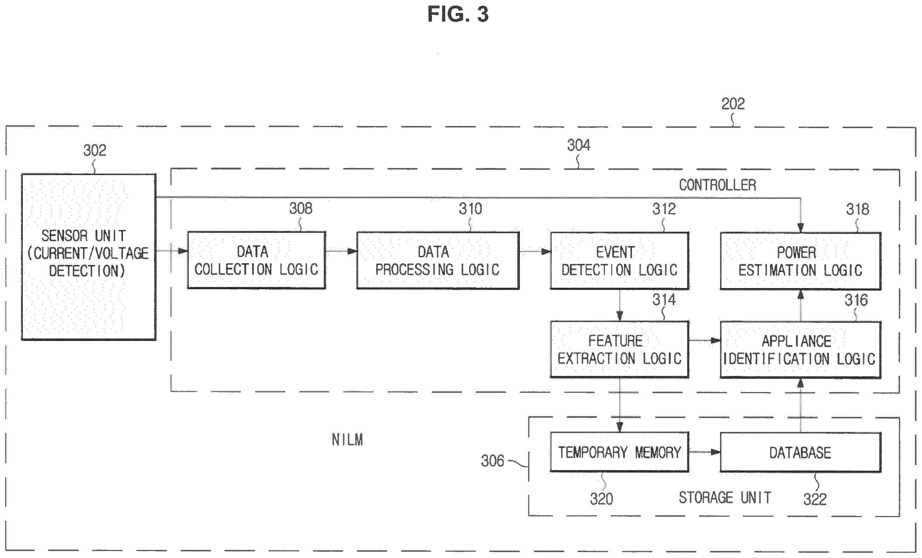

FIG. 3 is a view illustrating configuration of the NILM apparatus in accordance with the embodiment of the present disclosure. As exemplarily shown in FIG. 3, the NILM apparatus 202 in accordance with the embodiment of the present disclosure includes a sensor unit 302, a controller 304, and a storage unit 306. The sensor unit 302, the controller 304, and the storage unit 306 are mechanically and electrically connected, thus forming one independent apparatus, i.e., the NILM apparatus 202. For this purpose, the sensor unit 302, the controller 304, and the storage unit 306 may be mounted within one case. However, the sensor unit 302 may be installed on the distribution board 102 or a plug 110 separately from other components of the NILM apparatus 202. In this case, a wired communication method or a wireless communication method may be used for communication between the NILM apparatus 202 and the sensor unit 302 and, in this case, the NILM apparatus 202 and the sensor unit 302 may respectively include communication modules.

In the NILM apparatus 202 shown in FIG. 3, the sensor unit 302 serves to measure changes of electrical characteristics (for example, changes of voltage and current) in power lines used as transmission paths of power supplied to the home appliances 106. The storage unit 306 includes a temporary memory 320 and a database 322. The temporary memory 320 serves to temporarily store results of extraction of the intrinsic feature of the home appliances 106. The database 322 stores reference data to identify various kinds of home appliances, acquired through experimentation or learning. Such reference data is used to judge effectiveness of a corresponding result of extraction through comparison with the result of extraction of the intrinsic feature of the home appliance 106.

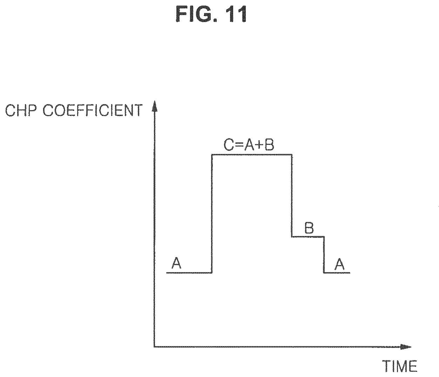

The controller 304 analyzes changes of electrical characteristics measured by the sensor unit 302, identifies the home appliance 106 which is a power consuming subject, based on a result of analysis, and predicts power consumption of the corresponding identified home appliance 106. For this purpose, the controller 304 includes a data collection logic 308, a data processing logic 310, an event detection logic 312, a feature extraction logic 314, an appliance identification logic 316, and a power estimation logic 318. The data collection logic 308 captures raw data, such as a steady-state signal and a transient signal from a detection signal from the sensor unit 302. The data processing logic 310 performs re-sampling to secure proper phase relations by aligning a current signal with a voltage signal, normalization to normalize data and to compensate for a specific power-quality related issue to achieve standardization, and filtering to extract harmonics characteristics (for example, current harmonic power (CHP)), with respect to the raw data captured by the data collection logic 308. Particularly, the data processing logic 310 calculates apparent power and real power of power consumption and generates information of a power factor from the apparent power and the real power. The event detection logic 312 detects an event occurring in the home appliance 106 based on the information of the power factor supplied from the data processing logic 310, i.e., information regarding change of the power factor (due to on/off conversion or operating state conversion of the home appliance 106). The feature extraction logic 314 extracts on/off times of the home appliance 106 and the intrinsic feature of the power consumption pattern of the home appliance 106 from the event detected by the event detection logic 312. For example, in the case of a washing machine, a power consumption pattern when a drum is rotated and a power consumption pattern when the drum is not rotated greatly differ, and rotating speeds of the drum in a washing cycle and a spin-drying cycle greatly differ and thus power consumption patterns in the washing cycle and the spin-drying cycle also greatly differ. However, a TV has a nearly regular power consumption pattern without change in the power-on state and thus greatly differs from the washing machine in terms of power consumption pattern. The feature extraction logic 314 extracts the intrinsic feature of the power consumption pattern of the home appliance 106 from a result of event detection of the event detection logic 312. The appliance identification logic 316 identifies the corresponding home appliance 106 and judges the operating state (for example, the on/off state or a specific operating mode, etc.) of the home appliance 106, through comparative analysis of feature data extracted by the feature extraction logic 314 (stored in the temporary memory 320) and reference data (stored in the database 322). Particularly, when a plurality of home appliances 106 is used, the appliance identification logic 316 identifies the plurality home appliances 106 using coefficients of the CHP acquired by the data collection logic 308 and the data processing logic 310 (with reference to FIG. 11). The power estimation logic 318 predicts a power consumption rate of the corresponding home appliance 106 using the power consumption information in the home (or workplace) 100 and the on/off information of the home appliance 106 measured by the sensor unit 302.

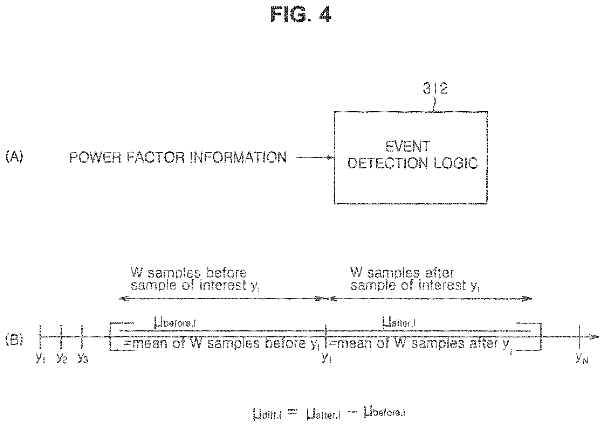

FIGS. 4(A) and 4(B) are views illustrating an event detection logic provided in a controller of an NILM apparatus in accordance with one embodiment of the present disclosure. As exemplarily shown in FIG. 4(A), power factor information is input to the event detection logic 312 in accordance with this embodiment of the present disclosure. Such power factor information is information generated by the data collection logic 308 and the data processing logic 310, and the event detection logic 312 detects an event occurring in the home appliance 106 using the power factor information. For this purpose, the event detection logic 312 may use a window-based first difference event detection method, as exemplarily shown in FIG. 4(B). In this case, the power factor is applied to 'W' in the first difference event detection method shown in FIG. 4(B).

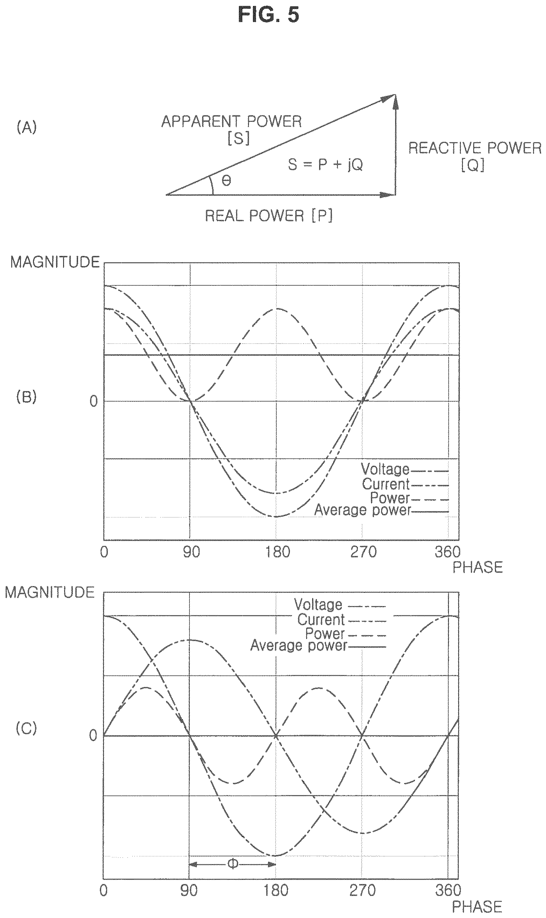

FIGS. 5(A) to 5(C) are views illustrating an event detection principle using a power factor in the event detection logic in accordance with the embodiment of the present disclosure.

First, FIG. 5(A) is a view illustrating relations among real power, reactive power, and apparent power. The power factor is defined as 'the ratio of real power to apparent power in an AC circuit'. If a resistance component of the AC current includes only pure resistance, the real power and the apparent power are equal. However, if reactance (inductance, capacitance, etc.) is present as the resistance component of the AC circuit, the apparent power is greater than the real power (active power) represented as heat, light, radio waves, etc. A portion of the apparent power exceeding the real power (i.e., extra power) becomes reactive power, and is mathematically expressed as an imaginary number. FIG. 5(A) shows relations between real power, reactive power, and apparent power. Further, a phase difference between a voltage waveform and a current waveform of power consumption may be detected from an angle θ of FIG. 5(A). If there is no phase difference between a voltage waveform and a current waveform, as exemplarily shown in FIG. 5(B), it may be understood that only a resistive load is present in the AC circuit and at this time, the power factor is 1. FIG. 5(C) illustrates a case in which a phase difference between a voltage waveform and a current waveform is 90 degrees and at this time, the power factor is 0. In this case, although current flows in the AC circuit, the average power is 0. Such a phase difference is generated due to reactance. If the AC circuit has inductive reactance, the phase of current may be late than the phase of voltage by at most 90 degrees (or a 1/4 cycle), and if the AC circuit has capacitive reactance, the phase of current may precede the phase of voltage by at most 90 degrees. That is, since the power factor is defined as the ratio of real power to apparent power in an AC circuit and corresponds to cosine Θ, as shown in FIG. 5(A), it may be understood that the value of the power factor is limited to the range of 0 to 1. This may exhibit the same effect as normalization of 0∼1 regardless of a power value (does not actually mean normalization) and thereby, the same event detection judgment value (a reference value (threshold value)) may be applied to all the home appliances 106 to detect events. Further, the power factor is changed when the state of the home appliance 106 is changed. For example, in case of a washing machine, since a pump motor operated to supply water and a drainage motor operated to drain water include different components, whenever each motor is used, the power factor of power consumption is changed when the internal state of the washing machine is changed (for example, a water supply mode is switched to a drainage mode). Therefore, in the NILM apparatus in accordance with the embodiment of the present disclosure, use of the power factor by the event detection logic may be advantageous in detection of a load, i.e., the home appliance 106, as compared to use of other factors.

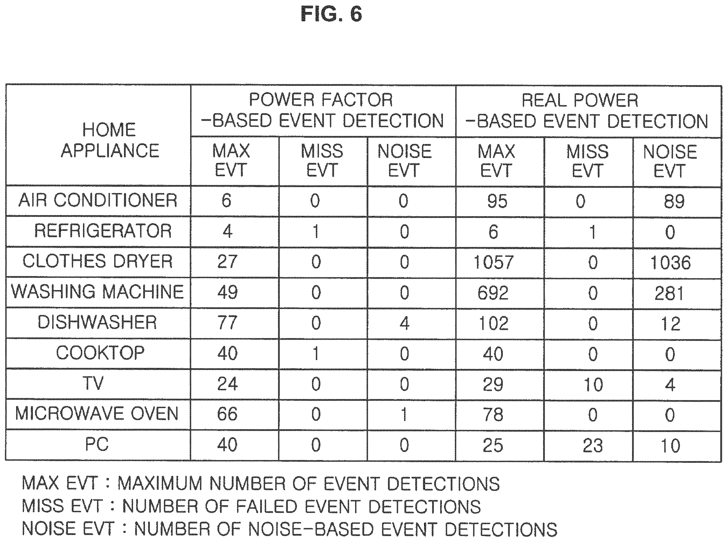

NILM may generally cause two problems generated due to high difference of power consumptions among respective loads. One is that, when a load having high power consumption is focused on, a high event detection success rate of a load having low power consumption is not expected. The other is that, when a load having low power consumption is focused on, plural noise-based event signals are generated. FIG. 6 is a table comparatively illustrating test results of the NILM apparatus using a power factor in accordance with the embodiment of the present disclosure and a conventional NILM apparatus using real power. With reference to FIG. 6, it may be understood that, if real power is used, the event detection failure rate of a home appliance having a comparatively low power consumption, such as a TV or a PC, is high. This corresponds to the front of the sequence of each logic of the NILM apparatus, and may influence all of the feature extraction logic, the appliance identification logic, and the power estimation logic. If the state change of a load is not correctly detected in event detection, a given operation is performed using false information in the subsequent operation and thus, wrong power consumption judgment may be carried out. Further, with reference to FIG. 6, since the maximum number of real power-based event detections is large, computational complexity during real power-based event detection is greatly increased as compared to power factor-based event detection.

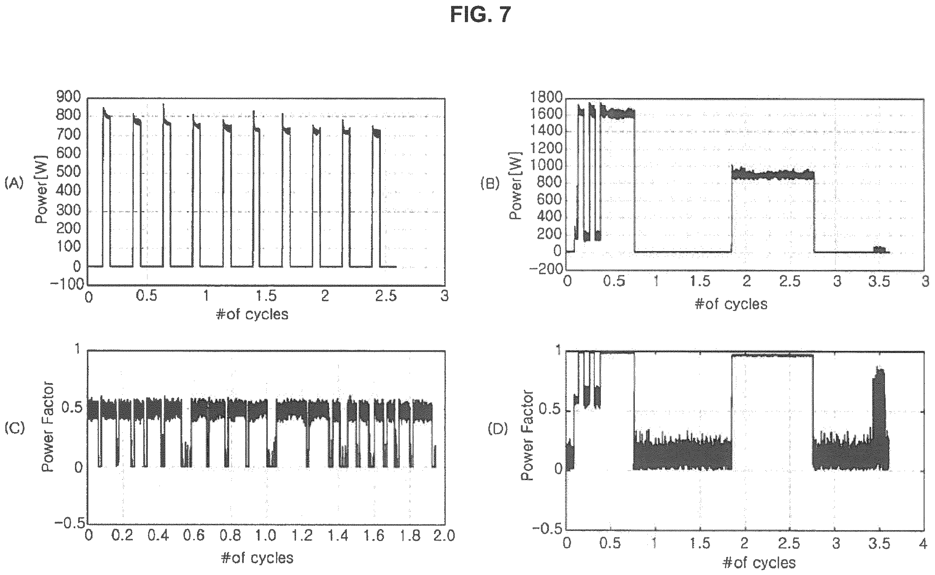

FIGS. 7(A) to 7(D) are graphs comparatively illustrating event detection using real power and event detection using a power factor in accordance with the embodiment of the present disclosure. FIGS. 7(A) and 7(B) are graphs illustrating real power-based event detection and it may be understood that the event detection success rate of a load having high real power (high power consumption) is relatively high, as exemplarily shown in FIG. 7(A), and the event detection success rate of a load having low real power (low power consumption) is relatively low, as exemplarily shown in FIG. 7(B). Differently, in the case of power factor-based event detection, as exemplarily shown in FIGS. 7(C) and 7(D), it may be understood that the event detection success rates of all loads are very high.

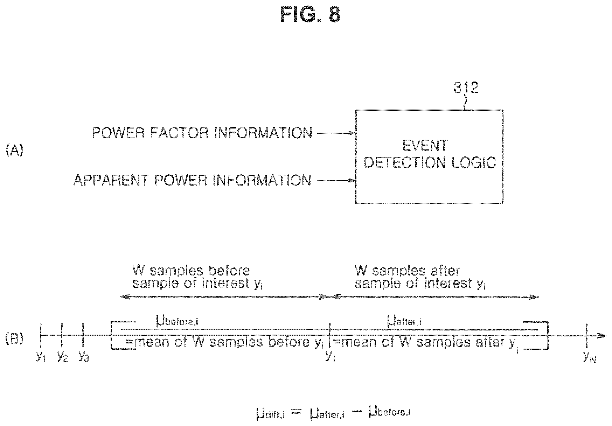

FIGS. 8(A) and 8(B) are views illustrating an event detection logic provided on a controller of an NILM apparatus in accordance with another embodiment of the present disclosure. As exemplarily shown in FIG. 8(A), both power factor information and apparent power information are input to the event detection logic 312 in accordance with this embodiment of the present disclosure. Such power factor information and apparent power information are generated by the data collection logic 308 and the data processing logic 310, and the event detection logic 312 detects an event occurring in the home appliance 106 using the power factor information and the apparent power information. When two or more home appliances having similar power factors are simultaneously operated, detection of events of the respective home appliances is not easy because difference of changes of the power factors is little. In order to solve such a problem, the apparent power information together with the power factor information is used and thus, the event detection success rates of respective loads having similar power factors may be increased when the loads are simultaneously operated. For this purpose, the event detection logic 312 may use a window-based first difference event detection method, as exemplarily shown in FIG. 8(B). In this case, the power factor is applied to 'W' in the first difference event detection method shown in FIG. 8(B).

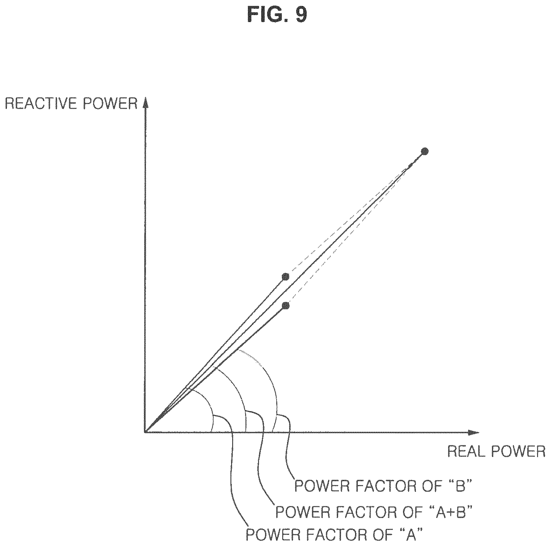

FIG. 9 is a graph illustrating event detection of the event detection logic in accordance with this embodiment of the present disclosure. As shown in FIG. 9, when two loads having similar power factors are simultaneously operated, difference of changes of the power factors is little, but apparent powers of the two loads greatly differ. Therefore, although plural loads having similar power factors are simultaneously operated, the event detection success rates of the respective loads may be greatly increased using both power factor information and apparent power information as input of the event detection logic 312.

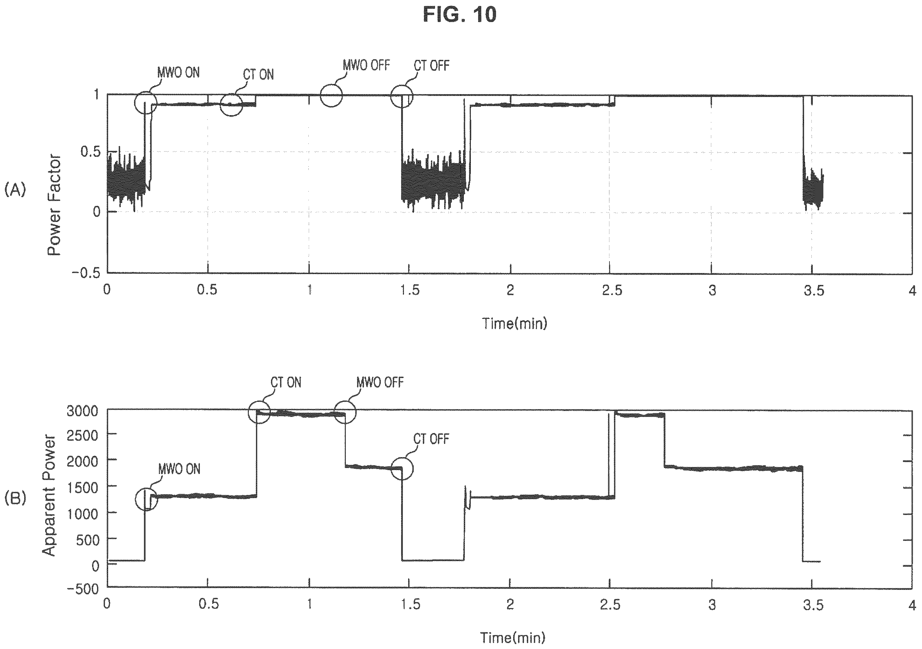

FIGS. 10(A) and 10(B) are graphs illustrating a power factor information-based event detection example and an apparent power information-based event detection example.

That is, FIG. 10(A) is a graph illustrating the power factor information-based event detection example, and FIG. 10(B) is a graph illustrating the apparent power information-based event detection example. First, as exemplarily shown in FIG. 10(A), since a power factor in a turning-on event (MWO ON) of a microwave oven and a power factor in a turning-on event (CT ON) of a cooktop are similar, the turning-on event (CT ON) of the cooktop may not be detected during power factor-based event detection. Further, a turning-off event (MWO OFF) of the microwave oven, occurring during turning-on of the cooktop, may also not be detected due to similarity in power factors. On the other hand, as exemplarily shown in FIG. 10(B), since apparent powers of the microwave oven and the cooktop having similar power factors are greatly different, during apparent power-based event detection, a turning-on event (MWO ON) of the microwave oven, a turning-on event (CT ON) of the cooktop, a turning-off event (MWO OFF) of the microwave oven, and a turning-off event (CT OFF) of the cooktop are clearly distinguishable and thus, the event detection success rates of the microwave oven and the cooktop are highly enhanced. In such a manner, if event detection is performed in consideration of both power factor and apparent power, although loads having similar power factors are simultaneously operated, events of the respective loads may be correctly detected.

FIG. 11 is a graph illustrating the concept of appliance identification using a current harmonic power (CHP) coefficient. As stated above with reference to FIG. 3, the appliance identification logic 316 of the NILM apparatus in accordance with the embodiment of the present disclosure identifies plural home appliances 106, when the plural home appliances are simultaneously operated, using CHP coefficients acquired by the data collection logic 308 and the data processing logic 310. Here, the appliance identification logic 316 may use the superposition theory. That is, if a CHP coefficient when a first home appliance is operated is "A" and a CHP coefficient when a second home appliance is operated is "B", as exemplarily shown in FIG. 11, "C" satisfies the equation C=A+B. Therefore, by judging to which one of A, B, and C a detected CHP coefficient corresponds, it may be detected which home appliance is operated at a given time. For this purpose, a database may be constructed by measuring CHP coefficients when various kinds of home appliances are respectively operated and CHP coefficients when various kinds of home appliances are simultaneously operated, and power consumption information of a home appliance may be acquired by measuring a CHP coefficient when power consumption of the home appliance is actually generated.

As is apparent from the above description, a non-intrusive load monitoring (NILM) apparatus and method in accordance with one embodiment of the present disclosure may detect an event of a power consuming load using a power factor and normalize power consumption of respective home appliances to a value between 0 and 1, thus applying one judgment value (threshold value) for event detection to all of the home appliances.

Further, the NILM apparatus and method may easily and correctly detect events occurring in loads regardless of the magnitudes of power consumption of individual home appliances as power consuming loads. Thereby, non-detection of an event of a power consumed appliance due to design of an algorithm focused on a load having a high power consumption or generation of a meaningless noise-based event due to design of an algorithm focused on a load having a low power consumption may be greatly reduced.

Although a few embodiments of the present disclosure have been shown and described, it would be appreciated by those skilled in the art that changes may be made in these embodiments without departing from the principles of the invention, the scope of which is defined in the claims.

## Claims

1. A non-intrusive load monitoring NILM apparatus comprising:
a sensor unit (302) to collect information regarding power consumption of home appliances; and
a controller (304) detecting power consumption-related events occurring in the home appliances by detecting state changes of a load based on power factor information and apparent power information among the power consumption information collected by the sensor unit, wherein the controller comprises:
an event detection logic (312) configured to receive the power factor information and apparent power information, and to detect the power-consumption related events by detecting state changes of a load based on the power factor information and apparent power information;
a feature extraction logic (314) extracting features of power consumption patterns of the home appliances from an event detection result of the event detection logic; and
an appliance identification logic (316) identifying the home appliances through analysis of data regarding the features extracted by the feature extraction logic.

2. The NILM apparatus according to claim 1, wherein the controller includes:
a data collection logic (308) capturing raw data from the power consumption information collected by the sensor unit and;
a data processing logic (310) acquiring apparent power and real power of the power consumption from the raw data and generating the power factor information from the apparent power and the real power.

3. The NILM apparatus according to claim 2, wherein the raw data includes steady-state signals and transient signals.

4. The NILM apparatus according to claim 2 or 3, wherein:
the data processing logic acquires current harmonic power CHP coefficients of the power consumption from the raw data; and
the appliance identification logic identifies the home appliances using the CHP coefficients.

5. The NILM apparatus according to claim 4, wherein the appliance identification logic uses the superposition theory when the appliance identification logic identifies the home appliances using the CHP coefficients.

6. A non-intrusive load monitoring NILM method comprising:
collecting information regarding power consumption of home appliances;
detecting power consumption-related events occurring in the home appliances by detecting a state change of a load based on power factor information and apparent power information among the collected power consumption information; and
extracting features of power consumption patterns of the home appliances from a result of the event detection; and
identifying the home appliances through analysis of data regarding the extracted features.

7. The NILM method according to claim 6, wherein the detection of the power consumption-related events includes:
capturing raw data from the power consumption;
acquiring apparent power and real power of the power consumption from the raw data and generating the power factor information from the apparent power and the real power; and
detecting the power consumption-related events based on the power factor information.

8. The NILM method according to claim 7, wherein the raw data includes steady-state signals and transient signals.

9. The NILM method according to claim any of claims 6 to 8, wherein:
current harmonic power CHP coefficients of the power consumption are acquired from the raw data; and
the identification of the home appliances is performed using the CHP coefficients.

10. The NILM method according to claim 9, wherein the superposition theory is used when the home appliances are identified using the CHP coefficients.

## Patentansprüche

1. Vorrichtung zum Non-Intrusive-Load-Monitoring (NILM), die Folgendes umfasst:
eine Sensoreinheit (302) zum Erheben von die Leistungsaufnahme von Haushaltsgeräten betreffenden Informationen; und
einen Kontroller (304), der in den Haushaltsgeräten auftretende, die Leistungsaufnahme betreffende Ereignisse erkennt, indem er Zustandsänderungen einer Last basierend auf Leistungsfaktorinformationen und Scheinleistungsinformationen unter den von der Sensoreinheit erhobenen Leistungsaufnahmeinformationen erkennt, wobei der Kontroller Folgendes umfasst:
eine Ereigniserkennungslogik (312), die dazu konfiguriert ist, die Leistungsfaktorinformationen und Scheinleistungsinformationen zu empfangen und die die Leistungsaufnahme betreffenden Ereignisse zu erkennen, indem sie Zustandsänderungen einer Last basierend auf den Leistungsfaktorinformationen und Scheinleistungsinformationen erkennt;
eine Merkmalsauszugslogik (314), die Merkmale von Leistungsaufnahmemustern der Haushaltsgeräte aus einem Ereigniserkennungsresultat der Ereigniserkennungslogik auszieht; und
eine Geräteidentifizierungslogik (316), die die Haushaltsgeräte durch Analyse von Daten identifiziert, die von der Merkmalsauszugslogik ausgezogene Merkmale betreffen.

2. NILM-Vorrichtung nach Anspruch 1, wobei der Kontroller Folgendes umfasst:
eine Datenerhebungslogik (308), die Rohdaten aus den von der Sensoreinheit erhobenen Leistungsaufnahmeinformationen erfasst; und
eine Datenverarbeitungslogik (310), die die Scheinleistung und die Wirkleistung der Leistungsaufnahme aus den Rohdaten gewinnt und die Leistungsfaktorinformationen aus der Scheinleistung und der Wirkleistung erzeugt.

3. NILM-Vorrichtung nach Anspruch 2, wobei die Rohdaten stationäre Signale und transiente Signale umfassen.

4. NILM-Vorrichtung nach Anspruch 2 oder 3, wobei:
die Datenverarbeitungslogik Stromoberwellenleistungs-Koeffizienten (Current-Harmonic-Power(CHP)-Koeffizienten) der Leistungsaufnahme aus den Rohdaten gewinnt; und
die Geräteidentifizierungslogik die Haushaltsgeräte unter Verwendung der CHP-Koeffizienten identifiziert.

5. NILM-Vorrichtung nach Anspruch 4, wobei die Geräteidentifizierungslogik die Überlagerungstheorie verwendet, wenn die Geräteidentifizierungslogik die Haushaltsgeräte unter Verwendung der CHP-Koeffizienten identifiziert.

6. Verfahren zum Non-Intrusive-Load-Monitoring (NILM), wobei das Verfahren Folgendes umfasst:
Erheben von die Leistungsaufnahme von Haushaltsgeräten betreffenden Informationen;
Erkennen von in den Haushaltsgeräten auftretenden, die Leistungsaufnahme betreffenden Ereignissen durch Erkennen einer Zustandsänderung einer Last basierend auf Leistungsfaktorinformationen und Scheinleistungsinformationen unter den erhobenen Leistungsaufnahmeinformationen; und
Ausziehen von Merkmalen von Leistungsaufnahmemustern der Haushaltsgeräte aus einem Resultat der Ereigniserkennung; und
Identifizieren der Haushaltsgeräte durch Analyse von die ausgezogenen Merkmale betreffenden Daten.

7. NILM-Verfahren nach Anspruch 6, wobei das Erkennen der die Leistungsaufnahme betreffenden Ereignisse Folgendes umfasst:
Erfassen von Rohdaten aus der Leistungsaufnahme;
Gewinnen der Scheinleistung und der Wirkleistung der Leistungsaufnahme aus den Rohdaten und Erzeugen der Leistungsfaktorinformationen aus der Scheinleistung und der Wirkleistung; und
Erkennen der die Leistungsaufnahme betreffenden Ereignisse basierend auf den Leistungsfaktorinformationen.

8. NILM-Verfahren nach Anspruch 7, wobei die Rohdaten stationäre Signale und transiente Signale umfassen.

9. NILM-Verfahren nach einem der Ansprüche 6 bis 8, wobei:
Stromoberwellenleistungs(CHP)-Koeffizienten der Leistungsaufnahme aus den Rohdaten gewonnen werden; und
die Identifizierung der Haushaltsgeräte unter Verwendung der CHP-Koeffizienten ausgeführt wird.

10. NILM-Verfahren nach Anspruch 9, wobei die Überlagerungstheorie verwendet wird, wenn die Haushaltsgeräte unter Verwendung der CHP-Koeffizienten identifiziert werden.

## Revendications

1. Appareil NILM (non-intrusive load monitoring - surveillance non intrusive de charge) comportant :
un ensemble capteur (302) servant à collecter des informations se rapportant à la consommation électrique d'appareils ménagers ; et
un dispositif de commande (304) servant à détecter des événements se rapportant à la consommation électrique se produisant dans les appareils ménagers par la détection de changements d'état d'une charge en se basant sur des informations se rapportant au facteur de puissance et sur des informations se rapportant à la puissance apparente parmi les informations se rapportant à la consommation électrique collectées par l'ensemble capteur, dans lequel le dispositif de commande comporte :
une logique de détection d'événements (312) configurée pour recevoir les informations se rapportant au facteur de puissance et les informations se rapportant à la puissance apparente, et pour détecter les événements se rapportant à la consommation électrique par la détection de changements d'état d'une charge en se basant sur les informations se rapportant au facteur de puissance et sur les informations se rapportant à la puissance apparente ;
une logique d'extraction de caractéristiques (314) servant à extraire des caractéristiques de modes de consommation électrique des appareils ménagers à partir d'un résultat de détection d'événements de la logique de détection d'événements ; et
une logique d'identification d'appareils (316) servant à identifier les appareils ménagers par l'analyse de données se rapportant aux caractéristiques extraites par la logique d'extraction de caractéristiques.

2. Appareil NILM selon la revendication 1, dans lequel le dispositif de commande comprend :
une logique de collecte de données (308) servant à capturer des données brutes à partir des informations de consommation électrique collectées par l'ensemble capteur et ;
une logique de traitement de données (310) servant à acquérir la puissance apparente et la puissance réelle de la consommation électrique à partir des données brutes et à générer les informations se rapportant au facteur de puissance à partir de la puissance apparente et de la puissance réelle.

3. Appareil NILM selon la revendication 2, dans lequel les données brutes comprennent des signaux à caractère constant et des signaux transitoires.

4. Appareil NILM selon la revendication 2 ou la revendication 3, dans lequel :
la logique de traitement de données acquiert des coefficients CHP (current harmonic power - puissance d'harmonique de courant) de la consommation électrique à partir des données brutes ; et
la logique d'identification d'appareils identifie les appareils ménagers par l'utilisation des coefficients CHP.

5. Appareil NILM selon la revendication 4, dans lequel la logique d'identification d'appareils utilise la théorie de superposition quand la logique d'identification d'appareils identifie les appareils ménagers par l'utilisation des coefficients CHP.

6. Procédé NILM (non-intrusive load monitoring - surveillance non intrusive de charge) comportant les étapes consistant à :
collecter des informations se rapportant à la consommation électrique d'appareils ménagers ;
détecter des événements se rapportant à la consommation électrique se produisant dans les appareils ménagers par la détection d'un changement d'état d'une charge en se basant sur des informations se rapportant au facteur de puissance et sur des informations se rapportant à la puissance apparente parmi les informations collectées se rapportant à la consommation électrique ; et
extraire des caractéristiques de modes de consommation électrique des appareils ménagers à partir d'un résultat de la détection d'événements ; et
identifier les appareils ménagers par le biais de l'analyse de données se rapportant aux caractéristiques extraites.

7. Procédé NILM selon la revendication 6, dans lequel la détection des événements se rapportant à la consommation électrique comprend les étapes consistant à :
capturer des données brutes d'après la consommation électrique ;
acquérir la puissance apparente et la puissance réelle de la consommation électrique à partir des données brutes et générer les informations se rapportant au facteur de puissance à partir de la puissance apparente et de la puissance réelle ; et
détecter les événements se rapportant à la consommation électrique en se basant sur les informations se rapportant au facteur de puissance.

8. Procédé NILM selon la revendication 7, dans lequel les données brutes comprennent des signaux à caractère constant et des signaux transitoires.

9. Procédé NILM selon l'une quelconque des revendications 6 à 8, dans lequel :
des coefficients CHP (current harmonic power - puissance d'harmonique de courant) de la consommation électrique sont acquis à partir des données brutes ; et
l'identification des appareils ménagers est effectuée par l'utilisation des coefficients CHP.

10. Procédé NILM selon la revendication 9, dans lequel la théorie de superposition est utilisée quand les appareils ménagers sont identifiés par l'utilisation des coefficients CHP.
